# EUROPÄISCHE PATENTSCHRIFT

(11) **EP 1 806 795 B1**
(45) Veröffentlichungstag und Bekanntmachung des Hinweises auf die Patenterteilung: **09.07.2008**
(21) Anmeldenummer: 05028081.7
(22) Anmeldetag: 21.12.2005
(51) Int. Cl.: H01L 51/50

(54) **Organisches Bauelement**
Organic Device
Dispositif organique

(43) Veröffentlichungstag der Anmeldung: 11.07.2007
(73) Patentinhaber: Novaled AG, 01307 Dresden (DE)
(72) Erfinder: Murano, Sven, Dr., 01099 Dresden (DE); Birnstock, Jan, Dr., 01187 Dresden (DE); Werner, Ansgar, 01277 Dresden (DE); Vehse, Martin, Dr., 01324 Dresden (DE); Hofmann, Michael, 01187 Dresden (DE)
(74) Vertreter: Bittner, Thomas L.

(56) Entgegenhaltungen:
- WO-A-20/05086251
- US-A1- 2005 110 009
- ZHOU X ET AL: "ENHANCED HOLE INJECTION INTO AMORPHOUS HOLE-TRANSPORT LAYERS OF ORGANIC LIGHT-EMITTING DIODES USING CONTROLLED P-TYPE DOPING" ADVANCED FUNCTIONAL MATERIALS, WILEY VCH, WIENHEIM, DE, Bd. 11, Nr. 4, August 2001 (2001-08), Seiten 310-314, XP001042080 ISSN: 1616-301X
- BLOCHWITZ J ET AL: "INTERFACE ELECTRONIC STRUCTURE OF ORGANIC SEMICONDUCTORS WITH CONTROLLED DOPING LEVELS" ORGANIC ELECTRONICS, ELSEVIER, AMSTERDAM, NL, Bd. 2, Nr. 2, September 2001 (2001-09), Seiten 97-104, XP001100424 ISSN: 1566-1199

## Beschreibung

Die Erfindung bezieht sich auf ein organisches Bauelement mit einer Elektrode und einer Gegenelektrode sowie einer Anordnung organischer Schichten, die zwischen der Elektrode und der Gegenelektrode angeordnet ist und die mit der Elektrode und der Gegenelektrode in elektrischem Kontakt ist, wobei die Anordnung organischer Schichten Ladungsträgertransportschichten zum Transportieren von aus der Elektrode und aus der Gegenelektrode in die Anordnung organischer Schichten injizierten Ladungsträgern umfasst.

### Stand der Technik

Solche Bauelemente sind in verschiedenen Ausführungen bekannt, insbesondere als lichtemittierende organische Bauelemente. Eine Bauform lichtemittierender organischer Bauelemente sind organische Leuchtdioden (OLED). Organische Leuchtdioden sind seit der Demonstration niedriger Arbeitsspannungen von Tang et al. (vgl. C.W. Tang et al., Appl. Phys. Lett. 51 (12), 913 (1987)) aussichtsreiche Kandidaten für die Realisierung von neuartigen Beleuchtungs- oder Anzeigeelementen. Alle diese Bauelemente umfassen eine Folge dünner Schichten aus organischen Materialien, welche bevorzugt im Vakuum aufgedampft oder in ihrer polymeren oder oligomeren Form in Lösung prozessiert werden. Nach elektrischer Kontaktierung mittels Metallschichten, wodurch Kontakte hergestellt werden, bilden sie vielfältige elektronische oder optoelektronische Bauelemente, beispielsweise Dioden, Leuchtdioden, Photodioden, Transistoren und Gassensoren, die mit ihren Eigenschaften den etablierten Bauelementen auf der Basis anorganischer Schichten Konkurrenz machen.

Bei organischen Leuchtdioden wird mittels Injektion von Ladungsträgern, nämlich Elektronen aus einer Elektrode und Löchern aus einer Gegenelektrode oder umgekehrt, in eine hierzwischen angeordnete Anordnung organischer Schichten infolge einer angelegten äußeren. Spannung, der folgenden Bildung von Exzitonen (Elektron-Loch-Paare) in einer aktiven Zone und der strahlenden Rekombination dieser Exzitonen in einer Emissionszone, Licht erzeugt und von der Leuchtdiode emittiert.

Der Vorteil solcher Bauelemente auf organischer Basis gegenüber den konventionellen Bauelementen auf anorganischer Basis, zum Beispiel Halbleitern wie Silizium oder Galliumarsenid, besteht darin, dass es möglich ist, sehr großflächige Elemente herzustellen, also große Anzeigeelemente (Bildschirme, Screens). Die organischen Ausgangsmaterialien sind gegenüber den anorganischen Materialien relativ preisgünstig. Darüber hinaus können diese Materialien aufgrund ihrer gegenüber anorganischen Materialien geringen Prozesstemperatur auf flexible Substrate aufgebracht werden, was eine ganze Reihe von neuartigen Anwendungen in der Display- und Beleuchtungstechnik eröffnet.

In dem Dokument US 5,093,698 wird eine organische Leuchtdiode vom PTN-Typ (PIN-OLED) beschrieben, bei der es sich um eine organische Leuchtdiode mit dotierten Ladungsträgertransportschichten handelt. Insbesondere kommen drei organische Schichten zur Anwendung die sich zwischen zwei Elektroden befinden. N-artig und p-artig dotierte Schichten verbessern darin die Ladungsträgerinjektion und den Transport von Löchern und Elektronen in der jeweiligen dotierten Schicht. Die vorgeschlagene Struktur besteht aus mindestens drei Schichten mit mindestens fünf Materialien.

Die Energieniveaus HOMO ("*Highest Occupied Molecular Orbital -* höchstes besetztes Molekülorbital") und LUMO ("*Lowest Unoccupied Molecular Orbital -* niedrigstes unbesetztes Molekülorbital") sind bevorzugt so gewählt, dass beide Sorten von Ladungsträgern in der Emissionszone _{"}gefangen" werden, um eine effiziente Rekombination von Elektronen und Löchern zu gewährleisten. Die Beschränkung der Ladungsträger auf die Emissionszone wird mittels geeigneter Wahl der Ionisationspotentiale oder der Elektronenaffinitäten für die Emissionsschicht und /oder die Ladungsträgertransportschicht realisiert, was unten näher erläutert wird.

Es ist eine Vorraussetzung für die Erzeugung sichtbaren Lichtes, dass die in der Rekombinationszone gebildeten Exzitonen mindestens eine Energie besitzen, die der Wellenlänge des Lichtes entspricht, welches emittiert werden soll. Die höchsten Energien werden hierbei für die Erzeugung von blauem Licht benötigt, welches eine Wellenlänge im Bereich 400 bis 475 nm besitzt. Um die Injektion von Ladungsträgern aus den Ladungstransportschichten in die Emissionszone zu erleichtern, ist es sinnvoll, für diese Schichten bevorzugt Materialien als Matrixmaterialien zum Einsatz zu bringen, welche in ihren Energielagen an die Emissionszone angepasst sind, derart, dass bereits eine möglichst hohe Energiedifferenz zwischen. dem Niveau der Elektronen in der Elektronentransportschicht und dem Niveau der Löcher in der Löchertransportschicht besteht.

Die Funktionsweise von Licht emittierenden Bauelementen unterscheidet sich nicht von der Funktionsweise von Bauelementen, die elektromagnetische Strahlung nahe dem sichtbaren Spektralbereich emittieren, beispielsweise Infrarot- oder Ultraviolettstrahlung.

Bei Materialien für Elektronentransportschichten wurde in Untersuchungen gefunden, dass die Energie des LUMOs höchstens -2.7 eV oder weniger betragen sollte. Dies entspricht einem Wert von höchstens -2,1 V vs. Fc / Fc⁺ (vs. Ferrocen / Ferrocenium). Standardmaterialien, welche als Materialien für Elektronentransportschichten in OLEDs zum Einsatz kommen, verfügen über ein solches LUMO. beispielsweise BPhen (LUMO -2,33 eV) und Alq₃ (LUMO -2,47 eV). Bei den Materialien für Löchertransportschichten liegt das HOMO bevorzugt bei -4,8 eV oder kleiner, entsprechend 0 V vs. Fc / Fc⁺ (vs. Ferrocen / Ferrocenium) oder größer.

Zur Erzielung einer geeigneten Dotierwirkung müssen die p- und die n-Dotanden über bestimmte Reduktionspotentiale / Oxidationspotentiale verfügen, um eine Oxidation der Martix der Löchertransportschicht zur Erzielung einer p-Dotierung und eine Reduktion der Matrix der Elektronentransportschicht zur Erzielung einer π-Dotierung zu erreichen.

Zur Bestimmung eines Ionsiationspotentials ist Ultraviolett-Photoelektronenspektroskopie (UPS) die bevorzugte Methode (vgl. R. Schlaf et al., J. Phys. Chem. B 103, 2984 (1999). Üblicherweise werden Ionisationspotentiale im festen Zustand bestimmt. Es ist aber grundsätzlich auch möglich, die Gasphasenionisationspotentiale zu bestimmen. Die Meßwerte, die mittels der zwei unterschiedlichen Methoden erhalten werden, unterscheiden sich aber aufgrund von Wechselwirkungen, die im Festkörper auftreten. Ein Beispiel für solch einen Einfluss aufgrund einer Wechselwirkung ist die Polarisationsenergie eines Loches, welches infolge Photoionisation erzeugt wird (N. Sato et al., J. Chem. Soc. Faraday Trans. 2, 77, 1621 (1981)), Das Ionisationspotential entspricht dem Punkt, an welchem die Photoemission auf der Flanke hoher kinetischer Energien einsetzt, d.h. dem am schwächsten gebundenen Photoelektron.

Eine verwandte Methode, die inverse Photoelektronenspektroskopie (IPES), wird zur Bestimmung von Elektronenaffinitäten herangezogen (vgl. W. Gao et. al, Appl. Phys. Lett. 82, 4815 (2003), ist jedoch weniger etabliert. Alternativ können die Festkörperpotentiale mittels elektrochemischer Messungen von Oxidationspotentialen Eₒₓ und Reduktionspotentialen E_{rcd} in der Lösung, beispielsweise mittels Zyklovoltammetrie (CV), abgeschätzt werden (vgl. J. D. Anderson, J. Amer. Chem. Soc. 120, 9646 (1998)).

Es sind empirische Formeln zur Umrechnung der elektrochemischen Spannungsskala (Oxidationspotentiale) in die physikalische (absolute) Energieskala (Ionisationspotentiale) bekannt (vgl. beispielsweise B. W. Andrade et al., Org. Electron. 6, 11(2005); T. B. Tang, J. Appl. Phys. 59, 5 (1986); V.D. Parker, J. Amer. Chem. Soc. 96, 5656 (1974); L. L. Miller, J. Org. Chem. 37, 916 (1972), Y. Fu et al., J. Amer. Chem. Soc. 127, 7227 (2005)). Zwischen Reduktionspotential und Elektronenaffinität ist keine Korrelation bekannt, da sich Elekeonenaffinitäten nur schwer messen lassen. Deshalb werden vereinfacht die elektrochemische und die physikalische Energieskala über IP = 4.8 eV + e*Eₒₓ (vs. Ferrocen / Ferrocenium) und EA = 4.8eV + e*E_{red} (vs. Ferrocen / Ferrocenium) ineinander umgerechnet (vgl. B.W. Andrade, Org. Electron. 6, 11 (2005)). Die Umrechnung von verschiedenen Standardpotentialen oder Redoxpaaren wird beispielsweise in A J. Bard et al., "Electrochemical Methods: Fundamentals and Applications", Wiley. 2. Ausgabe 2000 beschrieben. Informationen zum Einfluß des für die Messung verwendeten Lösungsmittels ergeben sich aus N.G. Connelly et al., Chem. Rev., 96, 877 (1996).

Es ist üblich, die Begriffe Ionisationspotential und Elektronenaffinität mit den Begriffen Energie (oder -lage) des HOMO bzw. Energie (oder -lage) des LUMO synonym zu verwenden (Koopmans Theorem). Hierbei ist zu beachten, dass das Ionisationspotential / die Elektronenaffinität so angegeben werden, dass größere Werte eine stärkere Bindung des heraus gelösten / angelagerten Elektrons an das betreffende Molekül bedeuten. Die Energieskala der Molekülorbitale (z. B- HOMO oder LUMO) misst hierzu umgekehrt.

Die in der vorliegenden Anmeldung genannten Potentiale beziehen sich auf den Wert im Festkörper.

Aus dem Dokument US 5,093,698 ist eine Bauelementestruktur für eine OLED bekannt, die zu einer stark verbesserten. Ladungsträgerinjektion aus den Elektroden in die organischen Schichten führt. Dieser Effekt beruht auf einer starken Bandverbiegung der Energieniveaus in der organischen Schicht an der Grenzfläche zu den Elektroden (J. Blochwitz et al., Org. Electronics 2, 97 (2001)), wodurch eine Injektion von Ladungsträgern auf Basis eines Tunnelmechanismus ermöglicht wird. Die hohe Leitfähigkeit der dotierten Schichten vermindert zudem den dort auftretenden Spannungsabfall beim Betrieb der OLED.

Die Injektionsbarrieren, welche in OLEDs zwischen Elektroden und den Ladungsträgertransportschichten auftreten können, stellen eine der Hauptursachen für eine Erhöhung der Betriebsspannung gegenüber den thermodynamisch begründeten Mindestbetriebsspannungen dar. Aus diesem Grunde gibt es zahlreiche Bemühungen, die Injcktionsbarrieren zu verringern, beispielsweise mittels Verwendung von Kathodenmaterialien mit niedriger Austrittsarbeit, zum Beispiel Metalle wie Calcium, Magnesium oder Barium. Diese Materialien sind jedoch sehr reaktiv, schwer zu prozessieren und als Elektrodenmaterialien nur bedingt prozesstauglich. Außerdem gelingt eine Verringerung der Betriebsspannung durch Verwendung solcher Kathoden nur teilweise.

Eine weitere Möglichkeit zur Verbesserung der Injektion von Elektronen aus der Kathode in die Elektronentransportschicht besteht in der Verwendung von LiF oder anderen Lithiumverbindungen, welche als dünne Schicht zwischen eine Aluminiumkathode und die Elektronentransportschicht eingebracht werden. Es wird angenommen, dass hierbei Lithium gebildet wird, welches über eine geringere Austrittsarbeit als Aluminium verfügt (M. Matsumura et al., Appl. Phys. Lett., (20) 2872, (1998)). Diese Methode funktioniert jedoch nur bei Verwendung von Aluminium als Kathodenmaterial. Darüber hinaus ist eine genaue Schichtdickenkontrolle für die LiF-Schicht notwendig, da nur sehr dünne Schichten im Bereich einiger Nanometer den gewünschten Effekt hervorrufen. Für invertierte Strukturen, bei denen zuerst die Kathode und dann die organische Schichtsequenz abgeschieden, werden, funktioniert die Methode ebenfalls nicht befriedigend.

Es ist eine weitere Möglichkeit zur verbesserten Injektion aus der Kathode in die Elektronen-transportschicht bekannt (vgl. Bloom et al., J. Phys. Chem. B, (107) 2933, (2003)), bei der Organometallkomplexe mit einer geringen Austrittsarbeit als dünne Schicht zwischen der Kathode und der Elektronentransportschicht in OLEDs eingebracht werden.

Als Anodenmaterial kommen in OLEDs üblicherweise Materialien mit einer relativ hohen Austrittsarbeit zum Einsatz. Beispielsweise werden transparente leitfähige Oxide, zum Beispiel Indiumzinnoxid (ITO) oder Indiumzinkoxid (IZO), verwendet. Auch zur verbesserten Injektion von Löchern aus ITO-Anoden in die Löchertransportschichten von OLEDs wurden Anstrengungen unternommen. Beispielsweise kann mittels gezielter Behandlung der ITO-Oberfläche mit einem Sauerstoffplasma die Austrittsarbeit des ITOs erhöht werden (M. Ishii et al., J. Lumin., 1165, (2000)).

Darüber hinaus wird in den Dokumenten US 6,720,573 B2 sowie US 2004 / 0113547 A1 die Verwendung substituierter Hexaazatriphenylene als Schicht zur Löcherinjektion und / oder zum Löchertransport vorgeschlagen, wodurch die Injektionsbarriere zwischen Anode und Löchertransportschicht verringert wird. In dem Dokument US 2004 / 0113547 A1 wird eine _{"}virtuelle Elektrode" postuliert, welche sich bei der Verwendung einer Injektionsschicht aus Hexaazatriphenylenen bildet. Hierbei wird davon ausgegangen, dass das Material in der Injektionsschicht im reduzierten Zustand eine höhere Stabilität besitzt als im neutralen Zustand. Weiterhin verfügt das Material über eine geringe Elektronenmobilität und eine hohe Löchermobilität. In dem Dokument US 2004 / 0113547 A1 wird vorgeschlagen, dass freie Elektronen aus dem Anodenmaterial an die Hexaazatriphenylenschicht abgegeben werden, wodurch die Moleküle dieser Schicht teilweise reduziert werden. Da die Elektronen eine geringe Beweglichkeit in dem Material zeigen, verbleiben sie dicht an der Grenzfläche zur Anode, wo sie eine virtuelle Kathode ausbilden. Beim Anlegen einer Spannung wird nun aufgrund der unmittelbar an der Anode befindlichen "virtuellen Kathode", d.h. den negativen Ladungen, eine Injektion von Löchern aus der Anode in die Hexaazatriphenylenschicht erleichtert. Aufgrund der hohen Löchermobilität dieser Schicht wandern die Löcher dann schnell weiter in Richtung der echten Kathode.

Weiterhin wird in dem Dokument US 2004 / 0113547 A1 ausgeführt, dass diese Injektionsschicht insbesondere mit Anodenmaterialien mit einer niedrigen Austrittsarbeit zu guten Ergebnisse führt. Dieser Befund steht im Gegensatz zu üblichen Bestrebungen, Anodenmaterialien mit einer hohen Austrittsarbeit zu verwenden. Dies stellt offensichtlich jedoch eine Einschränkung hinsichtlich der Anwendbarkeit dieser Materialien dar.

Somit sind zwar sowohl für die Ladungsträgerinjektion aus der Anode als auch aus der Kathode in die Ladungsträgertransportschichten von OLEDs Vorschläge bekannt. Diese können allerdings die bestehende Injektionsproblematik nur teilweise lösen. Insbesondere ist nicht gewährleistet, dass die Injektion von Ladungsträgern in die Ladungsträgertransportschichten weitgehend barrierefrei erfolgt, wie es bei PIN-OLEDs der Fall ist.

Im folgenden wird näher auf die PIN-OLED Technologie eingegangen.

Weiterhin stellt der Transport der Ladungsträger eine mögliche Quelle für einen unerwünschten Spannungsabfall dar. In undotierten Schichten erfolgt der Ladungstransport gemäß der Theorie der raumiadungsbegrenzten Ströme (vgl. M.A. Lampert, Rep. Progr. Phys. 27, 329 (1964)). Hierbei hängt die Spannung, die für die Aufrechterhaltung einer bestimmten Stromdichte benötigt wird, zunimmt, mit zunehmender Schichtdicke und abnehmender Ladungsträgerbeweglichkeit. Organische Halbleitermaterialien verfügen heutzutage zwar über hohe Ladungsträgerbeweglichkeiten von größer 10⁻⁵ cm²/Vs, jedoch reichen diese oftmals nicht aus, um bei erhöhten Stromdichten, wie sie im Betrieb von OLEDs mit hohen Leuchtdichten benötigt werden, einen weitgehend spannungsverlustfreien Ladungsträgertransport zu gewährlcisten. Demgegenüber ist eine Mindestschichtdicke für die Transportschichtdicken einzuhalten, um beispielsweise Kurzschlüsse zwischen den Elektroden und Lumineszenzlöschung an den Metallkontakten zu vermeiden.

Für PIN-OLEDs sind die Leitfähigkeiten der dotierten Schichten gegenüber undotierten Schichten um bis zu fünf Größenordnungen und sogar darüber hinaus erhöht. Die Schicht verhält sich wie ein ohmscher Leiter, wodurch ein Spannungsabfall über den (dotierten) Ladungsträgertransportschichten auch bei einem OLED-Betrieb mit hohen Stromdichten sehr gering ist. Bei einer Leitfähigkeit von 10⁻⁵ S/cm fällt beispielsweise über einer 100 nm dicken dotierten organischen Ladungsträgertransportschicht bei einem Strom von 100 mA/cm² eine Spannung von 0,1 V ab. Im Falle einer undotierten Ladungsträgertransportschicht (Raumladungsbegrenzung des Stromes) mit einer Beweglichkeit von 10⁻⁵ cm²/Vs wird demgegenüber für diese Stromdichte eine Spannung von 5,4 V benötigt.

Im Dokument DE 100 58 578 C2 wurden Blockschichten zwischen der zentralen. Emissionsschicht und mindestens einer Ladungsträgertransportschicht eingefügt. Hierbei sind die Ladungsträgertransportschichten ebenfalls entweder mit Akzeptoren oder Donatoten dotiert. Beschrieben ist, wie die Energieniveaus der Blockmaterialien zu wählen sind, um Elektronen und Löcher in der Licht emittierenden Zone einzuschränken, d.h. zu verhindern, dass die Ladungsträger mittels Diffusion die Emissionszone verlassen. Somit ermöglicht die bekannte Struktur tatsächlich hohe Effizienzen, da die zusätzlichen Zwischenschichten auch als Pufferzone zu vormals möglichen Quenching-EfFekten an Dotandenstörstellen wirken.

Eine Lumineszenzlöschung kann durch mehrere Effekte hervorgerufen sein. Ein möglicher Mechanismus ist als Exziplexbildung bekannt. In einem solchen Fall befinden sich Löcher und Elektronen, die eigentlich miteinander auf einem Emittermolekül in der Emissionszone rekombinieren sollen, auf zwei unterschiedlichen Molekülen an einer der Grenzflächen zur Emissionsschicht. Dieser so genannte Exziplex-Zustand kann als ein Charge-Transfer-Exziton verstanden werden, wobei die beteiligten Moleküle unterschiedlicher Natur sind. Bei ungeeigneter Wahl der Materialien für Block- bzw. Emissionsschicht ist dieser Exziplex der energetisch niedrigstmögliche angeregte Zustand, so dass die Energie des eigentlich erwünschten Exzitons auf einem Emittermolekül in diesen Exziplex-Zustand übertragen werden kann. Das führt zu einer Verringerung der Quantenausbeute der Elektrolumineszenz und damit der O-LED. Dies geht einher mit einer rotverschobenen Elektrolumineszenz des Exziplexes, die dann aber in der Regel durch sehr geringe Quantenausbeuten gekennzeichnet ist.

Weitere in OLEDs auftretende Mechanismen der Lumineszenzlöschung entstehen durch Wechselwirkung von Exzitonen mit geladenen oder ungeladenen Dotiermolekülen einerseits und / oder mit Ladungsträgern andererseits. Der erste Mechanismus wird mittels Einsatz von undotierten Blockschichten aufgrund der kurzen Reichweite (zum Beispiel <10 nm) der Wechselwirkung effektiv unterdrückt. Da Ladungsträger bei Betrieb der OLED zwangsläufig in und in der Nähe der Emissionszone auftreten müssen, kann hier eine Optimierung nur dahingehend erfolgen, dass eine Anhäufung von Ladungsträgern zum Beispiel an einer Banddiskontinuität vermieden wird. Dies stellt insbesondere Anforderungen an die Wahl der Bandlagen für Blockmaterial und Emitter, um hier Barrieren für die Ladungsträgerinjektion und damit eine Anhäufung von Ladungsträgern zu vermeiden.

Die Verwendung von Zwischenschichten an der Grenzfläche zwischen den Transportschichten und der Emissionszone kann, neben den bereits beschriebenen Effekten zur Erhöhung der OLED-Effizienz durch die Unterdrückung nichtstrahlende Zerfallsprozesse der Exzitonen, darüber hinaus auch den Zweck erfüllen, dass die Ladungsträgerinjektion in die Emissionszone erleichtert wird. Zur Erzeugung sichtbaren Lichtes ist es notwendig, Exzitonen auf den Emittermolekülen zu generieren, welche mindestens eine Energie entsprechend der Wellenlänge des durch die OLED emittierten Lichtes besitzen. Diese Energie entspricht häufig einem Wert der größer ist als der durch die Differenz zwischen dem HOMO der Löchertransporterschicht und dem LUMO der Elektronentransportschicht definierten Niveauunterschied. Um nun eine zu hohe Injektionsbarriere aus den Ladungsträgertransportschichten in die Emissionszone zu vermeiden, welche zu einer erhöhten Ladungsträgerdichte an dieser Grenzfläche und der Ausbildung einer Raumladungszone führen könnte, ist es oftmals zweckmäßig, zusätzliche dünne Schichten mit Dicken im Bereich einiger Nanometer zwischen die Ladungsträgertransportschichten und die Emissionszone einzubringen. Diese sollten dann mit dem Niveau ihres. HOMOs (im Falle der Löchertransportschicht) bzw. ihres LUMOs (im Falle der Elektronentransportschicht) energetisch zwischen den Ladungsträgertransportschichten und den Niveaus der Emissionszone liegen, wodurch der Ladungsträgertransport erleichtert und die Ausbildung einer Raumladungszone unterdrückt wird.

OLEDs basierend auf der PIN Technologie erreichen mit geeigneten Schichtanordnungen sehr hohe Stromeffizienzen bei gleichzeitig sehr geringen Betriebsspannungen, wodurch es möglich wird, außergewöhnlich hohe Leistungseffizienzen von über 100 lm/W zu erreichen. (J. Bimstock et al., IDW, Proceedings, S. 1265-1268 (2004)), wie sie bisher mit alternativen Technologien nicht realisiert werden können.

Allerdings stellt die Realisierung von dotierten Ladungstrausportschichten eine zusätzliche technologische Hürde im Produktionsablauf einer OLED dar. Neben der Emissionszone, welche häufig durch Coverdampfung von zwei oder mehr Materialien in einer oder mehreren Schichten aufgebaut ist, müssen für PIN OLEDs zusätzlich die Transportschichten aus jeweils zwei Materialien hergestellt worden. Hierfür benötigt man folglich zwei Verdampferquellen, welche separat beheizt und kontrolliert werden müssen, womit naturgemäß eine aufwändigere und somit auch kostspieligere Konzeption der Produktionsanlage einhergeht. Auch andere Herstellungsverfahren der OLED-Schichten, beispielsweise mittels Aufwachsen der Schichten aus einem Trägergas, welches mit den OLED-Materialien beladen ist, sind bei gleichzeitiger Abscheidung komplexer. Für solche Verfahren ist insbesondere zu beachten, dass die Verdampfungstemperaturen der abzuscheidenden Materialien zweckmäßig nahe bei einander liegen sollten, um eine mögliche Abscheidung der weniger flüchtigen Substanz an kühleren Teilen in der Produktionsanlage zu verhindern. Wenn die Verdampfungstemperaturen jedoch zu weit auseinander liegen und somit die mit dem Gasstrom in Kontakt tretenden Teile der Anlage auf entsprechend hohe Temperaturen gebracht werden müssen, um eine solche Abscheidung zu vermeiden, so besteht die Gefahr der chemischen Zersetzung der flüchtigeren Komponente an den heißen Gefäßwänden. Darüber hinaus ist im Falle der Dotierung von Ladungstransportschichten auch denkbar, dass es bereits in der Gasphase zu einer Reaktion zwischen Transportmatrix und dem Dotanden kommen kann.

Das Dokument WO 2005/086251 A2 beschäftigt sich mit der Verwendung eines Metallkomplexes als n-Dotant für ein organisches halbleitendes Matrixmaterial, ein organisches Halbleitermaterial und ein elektronisches Bauteil sowie als Dotant und Ligand.

Eines der Hauptanwendungsgebiete für organische Leuchtdioden ist die Displaytechnologie. Sowohl im Bereich der Passivmatrix-Anzeigeelemente als auch im Bereich der Aktivmatrixanzeigeelemente haben OLEDs in den letzten Jahren zunehmend an Marktvolumen hinzu gewonnen, wobei der Preisdruck naturgemäß hoch ist. Insofern steht der erhöhte technologische Fertigungsaufwand bei der Herstellung von PIN-OLED Bauteilen der gegenüber konventionellen OLEDs verbesserten Leistungscharakteristik entgegen, wodurch der kommerzielle Erfolg der PIN-Technologie unter Umständen beeinträchtigt werden kann.

### Die Erfindung

Aufgabe der Erfindung ist es, ein organisches Bauelement mit einer verbesserten Ladungsträgerinjektion aus den Elektroden in eine Anordnung organischer Schichten zwischen den Elektroden zu schaffen.

Diese Aufgabe wird erfindungsgemäß durch ein organisches Bauelement, insbesondere lichtemittierendes organisches Bauelement, mit einer Elektrode und einer Gegenelektrode sowie einer Anordnung organischer Schichten gelöst, die zwischen der Elektrode und der Gegenelektrode angeordnet ist und die mit der Elektrode und der Gegenelektrode in elektrischem Kontakt ist, wobei die Anordnung organischer Schichten Ladungsträgertransportschichten zum Transportieren von aus der Elektrode und aus der Gegenelektrode in die Anordnung organischer Schichten injizierten Ladungsträgern umfassen, wobei in der Anordnung organischer Schichten zwischen der Elektrode und einer der Elektrode gegenüberliegend angeordneten Ladungsträgertransportschicht eine Injektionsschicht aus einem molekularen Dotierungsmaterial gebildet ist, die in Kontakt mit der der Elektrode gegenüberliegend angeordneten Ladungsträgertransportschicht ist, wobei das molekulare Dotierungsmaterial ein Molekulargewicht von mindestens 300 g/mol aufweist. Das molekulare Dotierungsmaterial weist ein Reduktionspotential gegenüber Fc / Fc⁺ von größer oder gleich etwa 0 V auf, wenn das Dotierungsmaterial vom p-Typ ist. Ein Oxidationspotential des molekularen Dotierungsmaterials beträgt gegenüber Fc / Fc⁺ weniger oder gleich etwa -1,5 V, wenn das molekulare Dotierungsmaterial vom n-Typ ist.

Wenn die Elektrode eine Anode ist, ist die der Anode gegenüberliegend angeordnete Ladungsträgertransportschicht eine Löchertransportschicht und die Injektionsschicht ist aus einem molekularen Dotierungsmaterial vom p-Typ. Wenn die Elektrode eine Kathode ist, ist die der Kathode gegenüberliegend angeordnete Ladungsträgertransportschicht eine Elektronentransportschicht, und die Injektionsschicht ist aus einem molekularen Dotierungsmaterial vom n-Typ.

Es wurde überraschend gefunden, dass mittels einer oder mehrerer Injektionsschichten aus molekularen Dotierungsmaterialien, wie sie beispielsweise in PIN OLEDs zum Dotieren von Ladungsträgertransportschichten verwendet werden, zwischen den Elektroden und den Ladungsträgertransportschichten, die Betriebsspannung beim Betreiben des organischen Bauelementes wesentlich reduziert werden kann. Es ist mit der Erfindung gelungen, die Einsatzspannung auf einen minimalen Wert zu senken, wie dies im Fall organischer lichtemittierenden Bauelemente bisher nur für OLEDs vom PIN-Typ erreichbar war.

Darüber hinaus wurde gefunden, dass aufgrund der Verwendung der Injektionsschicht(en) aus dem molekularen Dotierungsmaterial eine Degradation infolge von UV-Lichtbestrahlung des organischen Bauelementes, insbesondere bei lichtemittierenden organischen Bauelementen, verhindert ist, wodurch das Bauelement auch bei starker Lichtbestrahlung keinen Anstieg der Betriebsspannungen zeigt.

Die molekularen Dotierungsmaterialien sind molekulare Substanzen, die zum Bilden von Schichten mittels Vakuumverdampfung ohne Zersetzung abscheidbar sind. Es handelt sich um organische oder anorganische Substanzen, deren Moleküle mindestens sechs Atome umfassen, vorzugsweise mehr als zwanzig Atome. Darüber hinaus kann es sich bei dem molekularen Dotierungsmaterial um ein molekulares Salz handeln, bei dem wenigstens zwei molekulare Untereinheiten gebildet sind, wobei die Atome in den molekularen Untereinheiten wiederum mindestens sechs Atome umfassen, vorzugsweise mehr als zwanzig Atome. In analoger Weise kann es sich bei dem molekularen Dotierungsmaterial um einen molekularen Charge-Transfer-Komplex handeln, dessen Atome die vorgenannten Bedingungen erfüllen. Die molekularen Dotierungsmaterialien weisen ein Molekulargewicht von mindestens 300 g / mol auf.

Eine vorteilhafte Ausgestaltung der Erfindung sieht vor, dass in der Anordnung organischer Schichten zwischen der Gegenelektrode und einer der Gegenelektrode gegenüberliegend angeordneten Ladungsträgertransportschicht eine weitere Injektionsschicht aus einem weiteren molekularen Dotierungsmaterial mit einem Molekulargewicht von mindestens 300 g/mol gebildet ist, die in Kontakt mit der der Gegenelektrode gegenüberliegend angeordneten Ladungsträgertransportschicht ist. Hierdurch kann zusätzlich zu der verbesserten Injektion von Ladungsträgern aus der Elektrode auch die Injektion von Ladungsträgern aus der Gegenelektrode verbessert werden. Es wird die Ladungsträgerbalance im Bauteil verbessert, wodurch bei OLEDs die Effizienz ansteigt. Darüber hinaus wird außerdem die Betriebsspannung verringert, da nun an beiden Elektroden eine geringere Injektionsbarriere vorhanden ist.

Bei einer zweckmäßigen Ausführungsform der Erfindung kann vorgesehen sein, dass die der Elektrode gegenüberliegend angeordnete Ladungsträgertransportschicht eine dotierte Ladungsträgertransportschicht ist. Hierdurch werden die vorteilhaften Wirkungen der Erfindung mit den positiven Eigenschaften dotierter Transportschichten kombiniert. Eine solche Anordnung führt zu einer verbesserten. UV-Stabilität sowie zu einer noch weiter verbesserten Injektion von Ladungsträgern, wodurch gegebenenfalls die Betriebsspannung weiter absinkt.

Eine Weiterbildung der Erfindung sieht vor, dass die der Elektrode gegenüberliegend angeordnete Ladungsträgertransportschicht mit dem molekularen Dotierungsmaterial dotiert ist. Hierdurch werden keine zusätzlichen Quellen benötigt, der Fertigungsprozess wird gegebenenfallsbilliger und es werden weniger unterschiedliche Materialien benötigt.

Bei einer bevorzugten Ausführungsform der Erfindung kann vorgesehen sein, dass die der Gegenelektrode gegenüberliegend angeordnete Ladungsträgertransportschicht eine dotierte Ladungsträgertransportschicht ist. Eine Weiterbildung der Erfindung sicht vor, dass die der Elektrode gegenüberliegend angeordnete Ladungsträgertransportschicht mit dem weiteren molekularen Dotierungsmaterial dotiert ist.

In einer bevorzugten Weiterbildung der Erfindung ist vorgesehen, dass die Injektionsschjcht mit einer Dicke zwischen etwa 0,1 nm und etwa 100 nm, vorzugsweise mit einer Dicke zwischen etwa 0,5 nm und etwa 10 nm gebildet ist. Zweckmäßig sieht eine Fortbildung der Erfindung vor, dass die weitere Injektionsschicht mit einer Dicke zwischen etwa 0,1 nm und etwa 100 nm, vorzugsweise mit einer Dicke zwischen etwa 0,5 nm und etwa 10 nm gebildet ist. Mittels dünner Schichten lässt sich eine Minimierung von möglichen Absorptionsverlusten sowie des Materialverbrauchs erzielen.

Bei einer bevorzugten Ausführungsform der Erfindung kann vorgesehen sein, dass die Injektionsschicht in Kontakt mit der Elektrode ist. Alternativ ist bei einer vorteilhaften Weiterbildung der Erfindung vorgesehen, dass zwischen der Elektrode und der Injektionsschicht eine Metallschicht gebildet ist, die in Kontakt mit der Elektrode und der Injektionsschicht ist. Aus der Metallzwischenschicht erfolgt ebenfalls eine Injektion von Ladungsträgern in die Ladungsträgertransportschichten, so dass eine Verbesserung der Injektionseigenschaften auch an dieser Stelle erzielt wird.

Bei einer bevorzugten Ausführungsform der Erfindung kann vorgesehen sein, dass die weitere Injektionsschicht in Kontakt mit der Gegenelektrode ist. In einer alternativen Ausführung sieht eine Fortbildung der Erfindung vor, dass zwischen der Gegenelektrode und der weiteren Injektionsschicht eine weitere Metallschicht gebildet ist, die mit der Gegenelektrode und der weiteren Injektionsschicht in Kontakt ist.

In einer bevorzugten. Weiterbildung der Erfindung ist vorgesehen, dass eine oder mehrere der organischen Schichten in der Anordnung organischer Schichten mittels Vakuum verdampfung abgeschieden sind. Es kann weiterhin vorgesehen sein, dass eine oder mehrere der organischen Schichten in der Anordnung organischer Schichten als Polymerschichten gebildet sind.

Für den technischen Herstellungsprozess ist es weiterhin vorteilhaft, wenn die verwendeten molekularen Dotierungsmaterialien in einem Vakuumprozess verarbeitbar sind. Eine bevorzugte Ausgestaltung der Erfindung sieht vor, dass das molekulare Dotierungsmaterial und / oder das weitere molekulare Dotierungsmaterial eine Mindestverdampfungstemperatur von wenigstens 100 °C, vorzugsweise von wenigstens 140 °C, weiter bevorzugt von wenigstens 160 °C aufweisen. Hierdurch ist gewährleistet, dass es zu keiner Verschleppung des Dotierungsmaterials in andere funktionelle Schichten des Bauelements kommt, wodurch sich negative Wirkungen auf die Leistung des Bauelementes ergeben können. Insbesondere für eine Verwendung der Materialien in Massenproduktionsprozessen sind die Verdampfungstemperatur und der Dampfdruck der Dotierungsmaterialien zwei kritische Größen, weswegen zu geringe Verdampfungstemperaturen oder zu hohe Dampfdrücke bei Raumtemperatur ein Ausschlusskriterium für ansonsten geeignete Materialien in einem Produktionsprozess darstellen.

Darüber hinaus ist es vorteilhaft, wenn die molekularen Dotierungsmaterialien mittels Verdampfung reinigbar sind, so dass das Dotierungsmaterial in einem hohen Reinheitsgrad bei der Bauelementeherstellung zum Einsatz kommt. Hierzu ist vorgesehen, dass das Dotierungsmaterial bei einer Temperatur deutlich unterhalb der thermischen Zersetzungstemperatur des Dotierungsmaterials sublimierbar ist. Die Differenz zwischen Verdampfungstemperatur und der Zersetzungstemperatur beträgt mindestens etwa 20 °C, bevorzugt mindestens etwa 40 °C, weiter bevorzugt mindestens etwa 60 °C. Hierdurch wird auch gewährleistet, dass es während der Bauelementeherstellung nicht zu einer Zersetzung des Dotierungsmaterials in der Produktionsanlage und hierdurch zu einer Verunreinigung selbiger kommt. Zweckmäßig sieht deshalb eine Fortbildung der Erfindung vor, dass für das molekulare Dotierungsmaterial und / oder das weitere molekulare Dotierungsmaterial eine Differenz zwischen der Verdampfungstemperatur und der Zersetzungstemperatur wenigstens 20 °C, bevorzugt mindestens etwa 40 °C, weiter bevorzugt mindestens etwa 60 °C beträgt.

Eine bevorzugte Ausgestaltung der Erfindung sieht vor, dass das molekulare Dotierungsmaterial vom p-Typ ein Reduktionspotential aufweist, welches gegenüber Fc / Fc⁺ größer oder gleich etwa 0,18 V, vorzugsweise größer oder gleich etwa 0,24 V ist. Die Reduktionspotentiale lassen sich beispielsweise mittels Cyclovoltametrie der Substanzen in einem geeigneten Lösungsmittel, beispielsweise Acetonitril, bestimmen. Detaillierte Angaben zur Durchführung von Zyklovoltammetrie sowie andere Methoden zur Bestimmung von Reduktionspotentialen und die Relationen zwischen der Referenzelektrode Ferrocen / Ferrocenium (Fc / Fc⁺) und anderen Referenzelektroden können in A. J. Bard et al., "Electrochemical Methods: Fundamentals and Applications", Wiley, 2nd edition 2000, gefunden werden. Je größer das Reduktionspotential, desto größer ist die Vielfalt

der Materialien, die als Lochtransportschicht eingesetzt werden können. Hierdurch können preiswerte, stabilere (UV/Temperatur) und langlebigere Materialien verwendet werden.

Bei einer vorteilhaften Weiterbildung der Erfindung ist vorgesehen, dass die Gegenelektrode eine Kathode ist, die der Kathode gegenüberliegend angeordnete Ladungsträgertransportschicht eine Elektronentransportschicht ist und die weitere Injektionsschicht aus einem molekularen Dotierungsmaterial vom n-Typ ist.

Eine bevorzugte Ausführungsform der Erfindung sieht vor, dass das molekulare Dotierungsmaterial vom n-Typ ein Oxidationspotential aufweist, welches gegenüber Fc / Fc⁺ kleiner oder gleich etwa -2,0 V, vorzugsweise kleiner oder gleich etwa -2,2 V ist. Je kleiner das Oxidationspotential, desto größer ist die Vielfalt der Materialien, die als Elektronentransportschicht eingesetzt werden können.

Bei der Nutzung undotierter Ladungsträgertransportschichten entfällt die Notwendigkeit, die Ladungsträgertransportschichten mittels Coverdampfung mehrerer Materialien herzustellen, wodurch die Herstellung im Vergleich zur Ausbildung dotierter Schichten vereinfacht ist.

Die Erfindung entfaltet die beschriebenen Vorteile insbesondere in Verbindung mit lichtemittierenden organischen Bauelementen. Eine bevorzugte Ausführungsform der Erfindung sieht vor, dass die Anordnung organischer Schichten einen lichtemittierenden Bereich umfasst, so daß ein lichtemittierendes organisches Bauelement gebildet ist. In einer Ausgestaltung kann gegebenenfalls auf Zwischenschichten zwischen den Ladungsträgertransportschichten und dem lichtemittierenden Bereich verzichtet werden, da für den Fall des Verzichtes auf dotierte Transportschichten keine Lumineszenzlöschung durch Wechselwirkung von Exzitonen mit geladenen oder ungeladenen Dotiermolekülen auftreten kann.

Bei einer vorteilhaften Weiterbildung der Erfindung ist vorgesehen, dass das lichtemittierende organische Bauelement top-emittierend ist. Zweckmäßig sieht eine alternative Fortbildung der Erfindung vor, dass das lichtemittierende organische Bauelement bottom-emittierend ist. Es kann vorgesehen sein, dass das lichtermittierende organische Bauelement transparent ist. Auch eine invertierte Anordnung kann vorgesehen sein.

### Beschreibung bevorzugter Ausführungsformen der Erfindung

Die Erfindung wird im folgenden anhand von Ausführungsbeispielen unter Bezugnahme auf Figuren einer Zeichnung näher erläutert. Hierbei zeigen:
- Fig. 1: eine schematische Darstellung eines organischen Bauelementes, bei dem zwischen einer Anode und einer Kathode eine Anordnung organischer Schichten angeordnet ist;
- Fig. 2: eine schematische Darstellung eines lichtemittierenden organischen Bauelementes, bei dem zwischen der Anode und der Kathode die Anordnung organischer Schichten mit einer lichtemittierenden Schicht angeordnet ist;
- Fig. 3: eine grafische Darstellung der Leuchtdichte in Abhängigkeit von der Spannung für eine erfindungsgemäße lichtemittierende organische Leuchtdiode und eine lichtemittierende organische PIN-Leuchtdiode nach dem Stand der Technik; und
- Fig. 4: eine grafische Darstellung der Stromdichte in Abhängigkeit von der Spannung für die erfindungsgemäße lichtemittierende organische Leuchtdiode und die lichtemittierende organische PIN-Leuchtdiode nach dem Stand der Technik.

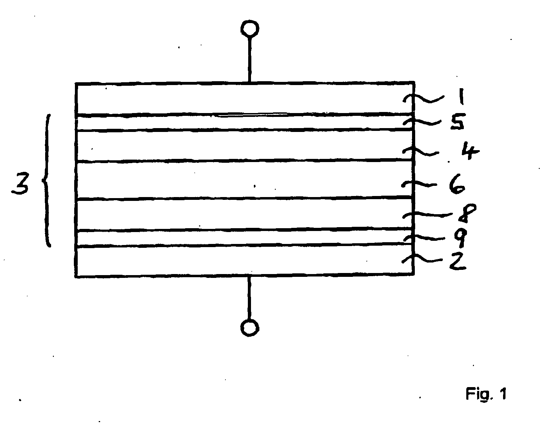

Fig. 1 zeigt eine schematische Darstellung eines organischen Bauelementes, bei dem zwischen einer Anode 1 und einer Kathode 2 eine Anordnung organischer Schichten 3 gebildet ist. Über die Anode 1 und die Kathode 2 kann an die Anordnung organischer Schichten 3 mit einer elektrischen Spannung angelegt werden. Ein solcher Aufbau kann in verschiedene organische Bauelemente integriert werden, beispielsweise Dioden, Leuchtdioden, Photodioden oder dergleichen.

Die Anordnung organischer Schichten 3 umfasst eine der Anode 1 gegenüberliegend angeordnete Löchertransportschicht 4. Mit Hilfe der Löchertransportschicht 4 werden in der Anordnung organischer Schichten 3 Löcher, die beim Anlegen der elektrischen Spannung aus der Anode 1 über einer anodenseitige Injektionsschicht 5 aus einem molekularen Dotierungsmaterial vom p-Typ injiziert werden, zu einer aktiven Zone 6 transportiert. Als molekulares Dotierungsmaterial, vom p-Typ ist beispielsweise das folgenden Material nutzbar: 2-(6-Dicyanomethylen-1,3,4,5,7,8-hexafluoro-*6H*-naphtalen-2-ylidene)-malononitril.

Bei der aktiven Zone 6 handelt es sich beispielsweise um eine lichtemittierende Zone, in welcher die Löcher und die Elektronen unter Abgabe von Licht rekombinieren.

Gemäß Fig. 1 umfasst die Anordnung organischer Schichten 3 weiterhin eine der Kathode 2 gegenüberliegend angeordnete Elektronentransportschicht 8. Mit Hilfe der Elcktrozentransportschicht 8 werden in der Anordnung organischer Schichten 3 Elektronen, die beim Anlegen der elektrischen Spannung aus der Kathode 2 über einer kathodenseitige Injektionsschicht 9 aus einem molekularen Dotierungsmaterial vom n-Typ injiziert werden, zu der aktiven Zone 6 transportiert. Als molekulares Dotierungsmaterial vom n-Typ ist beispielsweise das folgenden Material nutzbar: Tetrakis(1,3,4,6,7,8-hexahydro-2H-pyrimido[1,2-a]pyrimidinato) di-Wolfram (II).

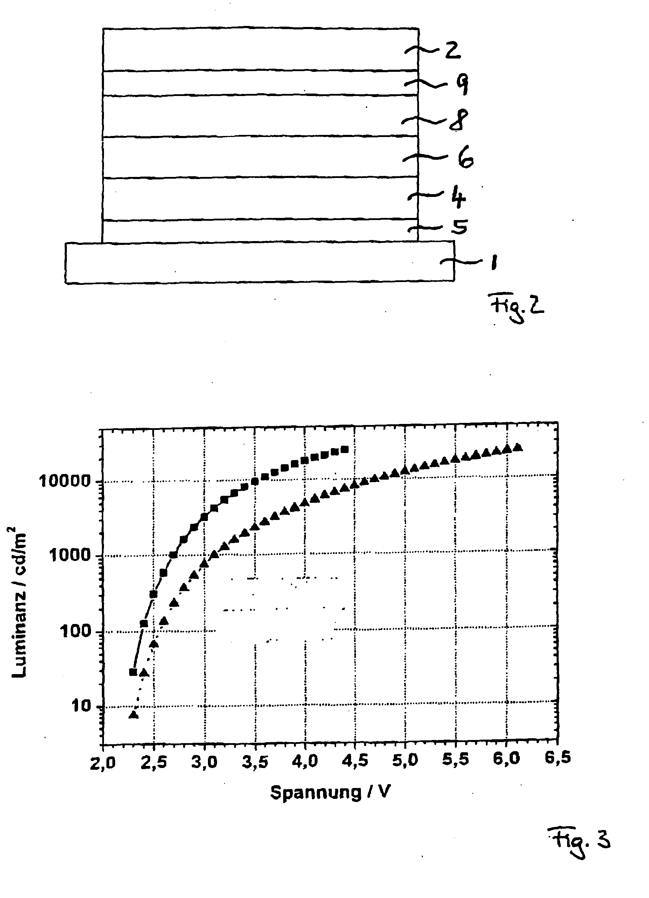

Fig. 2 zeigt eine schematische Darstellung eines lichtemittierenden organischen Bauelementes, bei dem zwischen der Anode 1 und der Kathode 2 die Anordnung organischer Schichten 3 mit der als lichtemittierende Schicht ausgebildeten aktiven Zone 6 angeordnet ist.

Die in den Fig. 1 und 2 dargestellten organischen Bauelemente können in anderen Ausruhrungsformen (nicht dargestellt) weitere Schichten in der Anordnung organischer Schichten. 3 oder außerhalb der Anordnung organischer Schichten 3 aufweisen. So sind insbesondere für lichtemittierende organische Bauelemente Ausführungen bekannt, bei denen Zwischenschichten vorgesehen sind, die zum Blockieren von Ladungsträgern dienen.

Fig. 3 zeigt eine grafische Darstellung der Leuchtdichte in Abhängigkeit von der Spannung für eine erfindungsgemäße lichtemittierende organische Leuchtdiode (erfindungsgemäße O-LED; Dreiecke) und eine lichtemittierende organische PIN-Leuchtdiode nach dem Stand der Technik (PIN-OLED nach dem Stand der Technik; Vierecke).

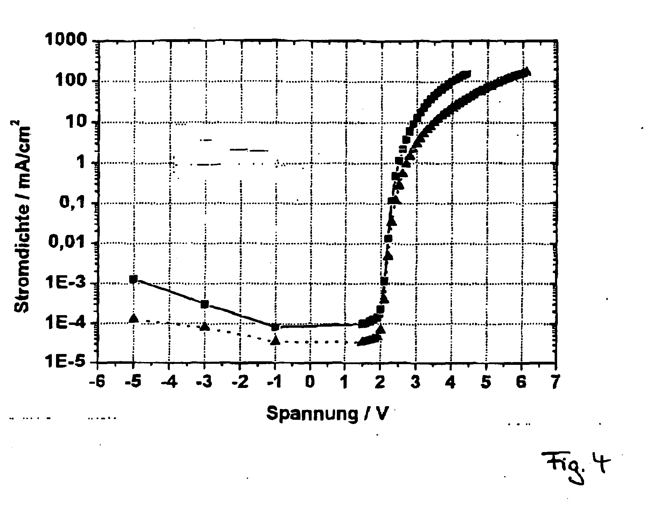

Fig. 4 zeigt eine grafische Darstellung der Stromdichte in Abhängigkeit von der Spannung für die erfindungsgemäße OLED (Dreiecke) und die PIN-OLED nach dem Stand der Technik (Vierecke).

Zur Herstellung der beiden OLEDs wurden die organischen Schichten sowie die Metallschichten mittels thermischer Verdampfung auf ITO-beschichtetem Glas in einem Ultrahochvakuumsystem bei einem Druck von etwa 10⁻⁷ mbar abgeschieden, ohne dass das Vakuum während der Herstellung unterbrochen wurde. Die Abscheideraten und -dicken wurden mittels Schwingquarzmonitoren kontrolliert.

Die erfindungsgemäße OLED weist folgenden Aufbau auf
1.1) 2 nm 2-(6-Dicyanomethylen-1,3,4,5,7,8-hexafluoro-6*H*-naphtalen-2-ylidene)-malononitril
1.2) 50 nm 2,2',7,7'-Tetrakis-(N,N-di-methylphenylamino)-9,9'spirobifluoren
1.3) 10 nm NPB
1.4) 20 nm NPB dotiert mit 10 % Iridium (III) bis(2-methyldibenzo[f,h]quinoxaline) (acetylacetonat)
1.5) 70 nm 2,4,7,9-Tetraphenyl-phenanthrolin
1.6) 2 nm Tetrakis(1,3,4,6,7,8-hexahydro-2H-pyrimido[1,2-a]pyrimidinato) di-Wolfram (II)
1.7) 100 nm Aluminium

Hierbei handelt es sich um eine rote OLED mit einem Emissionsmaximum bei 615 nm. Die Probe erreicht eine Helligkeit von 1000 cd/m² bei einer Spannung von 3,1 V. Die Stromeffizienz bei dieser Helligkeit beträgt 24 cd/A.

Die als Referenz hergestellte OLED nach dem Stand der Technik weist folgenden Aufbau auf:
2.1) 50 nm 2,2',7,7'-Tetrakis-(N,N-di-methylphenylamino)-9,9'-spirobifluoren dotiert mit 4 % 2-(6-Dicyanomethylen-1,3,4,5,7,8-hexafluoro-6H-naphtalen-2-ylidene)-malononitril
2.2) 10 nm NPB
2.3) 20 nm NPB dotiert mit 10 % Iridium (III) bis(2-methyldibenzo[f,h]quinoxaline) (acetylacetonat)
2.4) 10 nm 2,4,7,9-Tetraphenyl-phenanthrolin
2.5) 60 nm 2,4,7,9-Tetraphenyl-phenanthrolin dotiert mit 2 % Tetrakis(1,3,4,6,7,8-hexahydro-2H-pyrimido[1,2-a]pyrimidinato) di-Wolfram (II)
2.6) 100 nm Aluminium

Hierbei handelt es sich um eine rote OLED vom PIN-Typ mit einem Emissionsmaximum bei 610 nm. Die OLED erreicht eine Helligkeit von 1000 cd/m² bei einer Spannung von 2,7 V. Die Stromeffizienz bei dieser Helligkeit beträgt 26 cd/A.

Der Verlauf in Fig. 4 zeigt, dass bei niedrigen Stromdichten zunächst ein gleichartiger Anstieg sowohl für die erfindungsgemäße OLED als auch für die OLED nach dem Stand der Technik. Erst ab einer Stromdichte von 0,1 mA/cm² kommt es zu einer Abweichung in den Kurvenverläufen. Es kommt im Verlauf der Kurven zu einem langsameren Anstieg für die erfindungsgemäße OLED. Für eine Stromdichte von 10 mA/cm² wird für die OLED nach dem Stand der Technik eine um 0,5 V niedrigere Spannung benötigt als für die erfindungsgemäße OLED.

Die Injektion von Ladungsträgern aus der Anode und der Kathode erfolgt barrierefrei, so dass kein zusätzlicher Spannungsabfall aufgrund eines Kontaktwiderstandes auftritt. Insbesondere beträgt die Einsatzspannung nur 2.0 V. Demgegenüber beträgt die Energie der vom Bauelement emittierten Photonen ebenfalls nur 2.0 eV. Dies verdeutlicht ebenso, dass in der erfindungsgemäßen OLED und der OLED nach dem Stand der Technik keine Kontaktwiderstände auftreten,

Es ist überraschend, dass der Spannungsanstieg für das Erreichen bestimmter Stromdichten im Vergleich der erfindungsgemäßen OLED und der der OLED nach dem Stand nur so gering ist. Dies ist der Fall, obwohl die Gesamtschichtdicke der nicht dotierten Ladungstransportschichten bei der erfindungsgemäßen OLED über 100 nm dick ist.

Dies ist insbesondere auch im Vergleich zum Stand der Technik, überraschend. Es sind Injektionsschichten aus Materialien mit einem hohen Reduktionspotential als Löcherinjektionsschicht -0,6 V bis 0 V (vgl. US 2004/0113547 A1) und mit einem niedrigen Oxidationspotential von -1,28 V bis -1,44 V, zyklovoltammetrisch gemessen gegen eine Standardwasserstoffelektrode (Bloom et al., J. Phys. Chem. B, (107) 2933, (2003)), als Injektionsschicht für Elektronen bekannt. Für die bekannten Injektionsschichten aus dem Dokument US 2004 / 0113547 A1. werden spezielle Anodenmaterialien mit einer niedrigen Austrittsarbeit zur Erzielung niedriger Betriebsspannungen benötigt. Die erreichten Schwellspannungen sind gegenüber der vorliegenden Erfindung höher, außerdem haben die Kennlinien einen flacheren Verlauf. Die bekannten Materialien mit niedrigem Oxidationspotential (vgl. Bloom et al., J. Phys. Chem. B, (107) 2933, (2003)) zeigen ebenfalls deutlich höhere Schwellspannungen im Vergleich zur vorliegenden Erfindung.

Mittels Verwendung von Injektionsschichten aus Dotierungsmaterialien, die für die Dotierung von Ladungsträgertransportschichten in PIN-OLEDs geeignet sind, kann gegenüber dem Stand der Technik eine wesentliche Verbesserung erzielt werden. Insbesondere ist die Elektronenaffinität des anodenseitig eingesetzten p-Dotanden höher als im Dokument US 2004 / 0113547 A1. Ebenso ist das Tonisationspotential des kathodenseitig eingesetzten p-Dotanden geringer als im Stand der Technik (vgl. Bloom et al., J. Phys. Chem. B, (107) 2933, (2003)). Erst dadurch lassen sich signifikant steilere Kennlinien realisieren bei einer gleichzeitig niedrigen Schwellspannung des OLED-Bauteils. Hierdurch lassen sich deutlich höhere Leistungseffizienzen erreichen. Dieser Entwicklungssprung gegenüber dem Stand der Technik ist überraschend und ließ sich aus den bisherigen Arbeiten weder ableiten noch war er durch sie nahe gelegt. Aufgrund der Möglichkeit, dicke Transportschichten zu verwenden, ist der Produktionsprozess gegenüber Schichtdickenvariationen unempfindlich, wodurch die Produktionsausbeute erhöht wird und die Kosten einer Bauteilfertigung insgesamt sinken.

Insbesondere für einen Helligkeitsbereich bis 1000 cd/m² ist der Unterschied der Betriebsspannungen zwischen der erfindungsgemäßen OLED und der OLED nach dem Stand der Technik gering. Für eine Vielzahl möglicher Anwendungen, beispielsweise für Aktivmatrixanzeigeelemente oder Beleuchtungselemente, sind Helligkeiten von 1000 cd/m² und kleiner vollkommen ausreichend. Somit stellt die Erfindung insbesondere für mögliche Anwendungen mit niedrigen bis mittleren Bauteilhehigkeiten eine sehr gute Alternative zur PIN-Technologie dar. Es lässt sich mit Hilfe der Erfindung vermeiden, dass eine Coverdampfung dotierter Ladungsträgertransportschichten zur Erzielung geringer Betriebsspannungen notwendig ist. Darüber hinaus kann gegebenenfalls auf Schichten verzichtet werden, welche in PIN-OLEDs zur Erzielung hoher Effizienzen benötigt werden. Dies betrifft die in PIN-OLEDs üblicherweise benötigten undotierten dünnen Zwischenschichten an der Grenzfläche zwischen den Ladungsträgertransportschichten und der Emissionszone.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Organisches Bauelement, insbesondere lichtemittierendes organisches Bauelement, mit einer Elektrode (1; 2) und einer Gegenelektrode (2; 1) sowie einer Anordnung organischer Schichten (3), die zwischen der Elektrode (1; 2) und der Gegenelektrode (2; 1) angeordnet ist und die mit der Elektrode (1; 2) und der Gegenelektrode (2; 1) in elektrischem Kontakt ist, wobei die Anordnung organischer Schichten (3) Ladungsträgertransportschichten (4, 8) zum Transportieren von aus der Elektrode (1; 2) und aus der Gegenelektrode (2; 1) in die Anordnung organischer Schichten (3) injizierten Ladungsträgern umfasst, wobei:
- in der Anordnung organischer Schichten (3) zwischen der Elektrode (1; 2) und einer der Elektrode (1; 2) gegenüberliegend angeordneten Ladungsträgertransportschicht (4; 8) eine Injektionsschicht (5; 9) aus einem molekularen Dotierungsmaterial gebildet ist, die in Kontakt mit der der Elektrode (1; 2) gegenüberliegend angeordneten Ladungsträgertransportschicht (4; 8) ist und
- das molekulare Dotierungsmaterial ein Molekulargewicht von mindestens 300 g/mol aufweist, und
wobei weiterhin die Injektionsschicht (5; 9) einer der folgenden Ausgestaltungen entsprechend gebildet ist:
- eine Injektionsschicht (5) aus einem molekularen Dotierungsmaterial vom p-Typ, welches gegenüber Fc / Fc⁺ ein Reduktionspotential von größer oder gleich etwa 0 V aufweist, wobei bei dieser Ausgestaltung die Elektrode eine Anode (1) und die der Anode (1) gegenüberliegend angeordnete Ladungsträgertransportschicht eine Löchertransportschicht (4) ist, und
- eine Injektionsschicht (9) aus einem molekularen Dotierungsmaterial vom n-Typ, welches gegenüber Fc / Fc⁺ ein Oxidationspotential von kleiner oder gleich -1,5 V aufweist, wobei bei dieser Ausgestaltung die Elektrode eine Kathode (2) und die der Kathode (2) gegenüberliegend angeordnete Ladungsträgertransportschicht eine Elektronentransportschicht (8) ist.

2. Organisches Bauelement nach Anspruch 1, **dadurch gekennzeichnet, dass** für den Fall, dass die Elektrode als Anode (1) gebildet ist, die Gegenelektrode eine Kathode (2) ist und in der Anordnung organischer Schichten (3) zwischen der Kathode (2) und einer der Kathode (2) gegenüberliegend angeordneten Ladungsträgertransportschicht, die als Elektronentransportschicht (8) ausgeführt ist, eine weitere Injektionsschicht (9) aus einem weiteren molekularen Dotierungsmaterial vom n-Typ gebildet ist, die in Kontakt mit der der Kathode (2) gegenüberliegend angeordneten Elektronentransportschicht (8) ist, wobei das weitere molekulare Dotierungsmaterial vom n-Typ ein Molekulargewicht von mindestens 300 g/mol aufweist.

3. Organisches Bauelement nach Anspruch 1 oder 2, **dadurch gekennzeichnet, dass** die der Elektrode (1; 2) gegenüberliegend angeordnete Ladungsträgertransportschicht (4; 8) eine dotierte Ladungsträgertransportschicht ist.

4. Organisches Bauelement nach Anspruch 3, **dadurch gekennzeichnet, dass** die der Elektrode (1; 2) gegenüberliegend angeordnete Ladungsträgertransportschicht (4; 8) mit dem molekularen Dotierungsmaterial dotiert ist.

5. Organisches Bauelement nach Anspruch 2, 3 oder 4, soweit auf Anspruch 2 rückbezogen, **dadurch gekennzeichnet, dass** die der Gegenelektrode (2) gegenüberliegend angeordnete Ladungsträgertransportschicht (8) eine dotierte Ladungsträgertransportschicht ist.

6. Organisches Bauelement nach Anspruch 5, **dadurch gekennzeichnet, dass** die der Gegenelektrode (2; 1) gegenüberliegend angeordnete Ladungsträgemansportschicht (8; 4) mit dem weiteren molekularen Dotierungsmaterial dotiert ist.

7. Organisches Bauelement nach einem der vorangehenden Ansprüche, **dadurch gekennzeichnet, dass** die Injektionsschicht (5; 9) mit einer Dicke zwischen etwa 0,1 nm und etwa 100 nm, vorzugsweise mit einer Dicke zwischen etwa 0,5 nm und etwa 10 nm gebildet ist.

8. Organisches Bauelement nach einem der Ansprüche 2 bis 7, soweit auf Anspruch 2 rückbezogen, **dadurch gekennzeichnet, dass** die weitere Injektionsschicht (9) mit einer Dicke zwischen etwa 0,1 nm und etwa 100 nm, vorzugsweise mit einer Dicke zwischen etwa 0,5 nm und etwa 10 nm gebildet ist.

9. Organisches Bauelement nach einem der Ansprüche 1 bis 8, **dadurch gekennzeichnet, dass** die Injektionsschicht (5; 9) in Kontakt mit der Elektrode (1; 2) ist.

10. Organisches Bauelement nach einem der Ansprüche 1 bis 8, **dadurch gekennzeichnet, dass** zwischen der Elektrode (1; 2) und der Injektionsschicht (5; 9) eine Metallschicht gebildet ist, die in Kontakt mit der Elektrode (1; 2) und der Injektionsschicht (5; 9) ist.

11. Organisches Bauelement nach einem der Ansprüche 2 bis 10, soweit auf Anspruch 2 rückbezogen, **dadurch gekennzeichnet, dass** die weitere Injektionsschicht (9) in Kontakt mit der Gegenelektrode (2) ist.

12. Organisches Bauelement nach einem der Ansprüche 2 bis 10, soweit auf Anspruch 2 rückbezogen, **dadurch gekennzeichnet, dass** zwischen der Gegenelektrode (2) und der weiteren Injektionsschicht (9) eine weitere Metallschicht gebildet ist, die mit der Gegenelektrode (2) und der weiteren Injektionsschicht (9) in Kontakt ist.

13. Organisches Bauelement nach einem der vorangehenden Ansprüche, **dadurch gekennzeichnet, dass** eine oder mehrere der organischen Schichten in der Anordnung organischer Schichten (3) als Vakuum verdampfte Schichten gebildet sind.

14. Organisches Bauelement nach einem der vorangehenden Ansprüche, **dadurch gekennzeichnet, dass** eine oder mehrere der organischen Schichten in der Anordnung organischer Schichten (3) als Polymerschichten gebildet sind.

15. Organisches Bauelement nach einem der vorangehenden Ansprüche oder einem der Ansprüche 2 bis 14, **dadurch gekennzeichnet, dass** das molekulare Dotierungsmaterial und / oder das weitere molekulare Dotierungsmaterial eine Mindestverdampfungstemperatur von wenigstens 100 °C, vorzugsweise von wenigstens 140 °C, weiter bevorzugt von wenigstens 160 °C aufweisen.

16. Organisches Bauelement nach einem der vorangehenden Ansprüche oder einem der Ansprüche 2 bis 15, **dadurch gekennzeichnet, dass** für das molekulare Dotierungsmaterial und / oder das weitere molekulare Dotierungsmaterial eine Differenz zwischen der Verdampfungstemperatur und der Zersetzungstemperatur wenigstens 20 °C, bevorzugt mindestens etwa 40 °C, weiter bevorzugt mindestens etwa 60 °C beträgt.

17. Organisches Bauelement nach einem der vorangehenden Ansprüche, **dadurch gekennzeichnet, dass** das molekulare Dotierungsmaterial vom p-Typ ein Reduktionspotential aufweist, welches gegenüber Fc / Fc⁺ größer oder gleich etwa 0,18 V, vorzugsweise größer oder gleich etwa 0,24 V ist.

18. Organisches Bauelement nach einem der vorangehenden Ansprüche, **dadurch gekennzeichnet, dass** das molekulare Dotierungsmaterial vom n-Typ ein Oxidationspotential aufweist, welches gegenüber Fc / Fc⁺ kleiner oder gleich etwa -2,0 V, vorzugsweise kleiner oder gleich etwa -2,2 V ist.

19. Organisches Bauelement nach Anspruch 2 oder nach einem der Ansprüche 3 bis 18, soweit rückbezogen auf Anspruch 2, **dadurch gekennzeichnet, dass** das weitere molekulare Dotierungsmaterial vom n-Typ ein Oxidationspotential aufweist, welches gegenüber Fc / Fc⁺ kleiner oder gleich etwa -1,5 V, vorzugsweise kleiner oder gleich etwa - 2,0 V und weiter bevorzugt kleiner oder gleich etwa -2,2 V ist.

20. Organisches Bauelement nach einem der vorangehenden Ansprüche, **dadurch gekennzeichnet, dass** die Anordnung organischer Schichten (3) einen lichtemittierenden Bereich (6) umfasst, so dass ein lichtemittierendes organisches Bauelement gebildet ist.

21. Organisches Bauelement nach Anspruch 20, **dadurch gekennzeichnet, dass** das lichtemittierende organische Bauelement top-emittierend ist.

22. Organisches Bauelement nach Anspruch 20, **dadurch gekennzeichnet, dass** das lichtemittierende organische Bauelement bottom-emittierend ist.

23. Organisches Bauelement nach einem der Ansprüche 20 bis 22, **dadurch gekennzeichnet, dass** das lichtemittierende organische Bauelement transparent ist.

## Claims

1. Organic component, in particular light-emitting organic component, having an electrode (1; 2) and a counterelectrode (2; 1) and also an arrangement of organic layers (3) which is arranged between the electrode (1; 2) and the counterelectrode (2; 1) and which is in electrical contact with the electrode (1; 2) and the counterelectrode (2; 1), the arrangement of organic layers (3) comprising charge carrier transport layers (4, 8) for transporting charge carriers injected from the electrode (1; 2) and from the counterelectrode (2; 1) into the arrangement of organic layers (3), wherein
- an injection layer (5; 9) made from a molecular doping material is formed in the arrangement of organic layers (3) between the electrode (1; 2) and a charge carrier transport layer (4; 8) arranged opposite to the electrode (1; 2), which injection layer is in contact with the charge carrier transport layer (4; 8) arranged opposite to the electrode (1; 2), and
- the molecular doping material is provided with a molecular weight of at least 300 g/mol, and
wherein further the injection layer (5; 9) is formed according to one of the following configurations:
- an injection layer (5) is made from a molecular doping material of the p type having a reduction potential which, with respect to Fc/Fc⁺, is greater than or equal to approximately 0 V, wherein the electrode is formed as an anode (1), and the charge carrier transport layer arranged opposite to the anode (1) is a hole transport layer (4), and
- an injection layer (9) is made from a molecular doping material of the n type having an oxidation potential which, with respect to Fc/Fc⁺, is less than or equal to approximately -1.5 V, wherein the electrode is formed as a cathode (2), and the charge carrier transport layer arranged opposite to the cathode (2) is a electron transport layer (8).

2. Organic component according to Claim 1, wherein, if the electrode is formed as an anode (1), the counterelectrode is a cathode (2), and a further injection layer (9) made from a further molecular doping material of the n type is formed in the arrangement of organic layers (3) between the cathode (2) and an electron transport layer (8) arranged opposite to the cathode (2), which further injection layer is in contact with the electron transport layer (8) arranged opposite to the cathode (2), the further molecular doping material of the n type having a molecular weight of at least 300 g/mol.

3. Organic component according to Claim 1 or 2, **characterized in that** the hole transport layer (4; 8) arranged opposite to the electrode (1; 2) is a doped charge carrier transport layer.

4. Organic component according to Claim 3, **characterized in that** the hole transport layer (4; 8) arranged opposite to the electrode (1; 2) is doped with the molecular doping material.

5. Organic component according to Claim 2 or one of the Claims 3 or 4, as far as dependent on Claim 2, **characterized in that** the electron transport layer (8; 4) arranged opposite to the counterelectrode (2; 1) is a doped charge carrier transport layer.

6. Organic component according to Claim 5, **characterized in that** the charge carrier transport layer (8; 4) arranged opposite to the counterelectrode (2; 1) is doped with the further molecular doping material.

7. Organic component according to one of the preceding claims, **characterized in that** the injection layer (5; 9) is formed with a thickness of between approximately 0.1 nm and approximately 100 nm, preferably with a thickness of between approximately 0.5 nm and approximately 10 nm.

8. Organic component according to Claim 2 or one of the Claims 3 to 7, as far as dependent on Claim 2, **characterized in that** the further injection layer (9) is formed with a thickness of between approximately 0.1 nm and approximately 100 nm, preferably with a thickness of between approximately 0.5 nm and approximately 10 nm.

9. Organic component according to one of the preceding claims, **characterized in that** the injection layer (5; 9) is in contact with the electrode (1; 2).

10. Organic component according to one of Claims 1 to 8, **characterized in that** a metal layer which is in contact with the electrode (1; 2) and the injection layer (5; 9) is formed between the electrode (1; 2) and the injection layer (5; 9).

11. Organic component according to Claim 2 or one of the Claims 3 to 10, as far as dependent on Claim 2, **characterized in that** the further injection layer (9) is in contact with the counterelectrode formed as the cathode (2).

12. Organic component according to Claim 2 or one of the Claims 3 to 10, as far as dependent on Claim 2, **characterized in that** a further metal layer which is in contact with the counterelectrode formed as the cathode (2) and the further injection layer (9) is formed between the counterelectrode formed as the cathode (2) and the further injection layer (9).

13. Organic component according to one of the preceding claims, **characterized in that** one or a plurality of the organic layers in the arrangement of organic layers (3) are formed as vacuum evaporated layers.

14. Organic component according to one of the preceding claims, **characterized in that** one or a plurality of the organic layers in the arrangement of organic layers (3) are formed as polymer layers.

15. Organic component according to one of the preceding claims, **characterized in that** the molecular doping material and / or the further molecular doping material have a minimum evaporation temperature of at least 100°C, preferably of at least 140°C, more preferably of at least 160°C.

16. Organic component according to one of the preceding claims, **characterized in that**, for the molecular doping material and / or the further molecular doping material, a difference between the evaporation temperature and the decomposition temperature is at least 20°C, preferably at least approximately 40°C, more preferably at least approximately 60°C.

17. Organic component according to one of the preceding claims, **characterized in that** the molecular doping material of the p type has a reduction potential which, with respect to Fc/Fc⁺, is greater than or equal to approximately 0.18 V, preferably greater than or equal to approximately 0.24 V.

18. Organic component according to one of the preceding claims, **characterized in that** the molecular doping material of the n type has an oxidation potential which, with respect to Fc/Fc⁺, is less than or equal to approximately -2.0 V, preferably less than or equal to approximately -2.2 V.

19. Organic component according to Claim 2 or one of the Claims 3 to 18, as far as dependent on Claim 2, **characterized in that** the further molecular doping material of the n type has an oxidation potential which, with respect to Fc/Fc⁺, is less than or equal to approximately -1.5 V, preferably less than or equal to approximately -2.0 V, and further preferably less than or equal to approximately -2.2 V

20. Organic component according to one of the preceding claims, **characterized in that** the arrangement of organic layers (3) comprises a light-emitting region (6), with the result that a light-emitting organic component is formed.

21. Organic component according to Claim 20, **characterized in that** the light-emitting organic component is top emitting.

22. Organic component according to Claim 20, **characterized in that** the light-emitting organic component is bottom emitting.

23. Organic component according to one of Claims 20 to 22, **characterized in that** the light-emitting organic component is transparent.

## Revendications

1. Composant organique, en particulier composant organique électroluminescent, avec une électrode (1 ; 2) et une contre-électrode (2 ; 1) ainsi qu'un arrangement de couches organiques (3) qui est disposé entre l'électrode (2 ; 1) et la contre-électrode (2 ; 1) et qui est en contact électrique avec l'électrode (2 ; 1) et la contre-électrode (2 ; 1), étant donné que l'arrangement de couches organiques (3) comprend des couches de transport de porteurs de charge (4, 8) pour le transport de porteurs de charge injectés de l"électrode (1 ; 2) et de la contre-électrode (2 ; 1) dans l'arrangement de couches organiques (3), étant donné que :
- est formée dans l'arrangement de couches organiques (3) entre l'électrode (1 ; 2) et une couche de transport de porteurs de charge (4 ; 8) disposée en face de l'électrode (1 ; 2) une couche d'injection (5 ; 9) en un matériau de dopage moléculaire qui est en contact avec la couche de transport de porteurs de charge (4 ; 8) disposée en face de l'électrode (1 ; 2) et
- le matériau de dopage moléculaire présente un poids moléculaire d'au moins 300 g/mol, et
étant donné que, par ailleurs, la couche d'injection (5 ; 9) est formée conformément à une des formes de réalisation suivantes :
- une couche d'injection (5) en un matériau de dopage moléculaire du type p qui présente un potentiel de réduction supérieur ou égal à environ 0 V par rapport à Fe / Fe⁺, étant donné que, pour cette forme de réalisation, l'électrode est une anode (1) et la couche de transport de porteurs de charge disposée en face de l'anode (1) est une couche de transport de trous (4), et
- une couche d'injection (9) en un matériau de dopage moléculaire du type n qui présente un potentiel d'oxydation inférieur ou égal à -1,5 V par rapport à Fe / Fe⁺, étant donné que, pour cette forme de réalisation, l'électrode est une cathode (2) et la couche de transport de porteurs de charge disposée en face de la cathode (2) est une couche de transport d'électrons (8).

2. Composant organique selon la revendication 1, **caractérisé en ce que,** pour le cas où l'électrode est formée comme anode (1), la contre-électrode est une cathode (2), et **en ce qu'**est formée dans l'arrangement de couches organiques (3) entre la cathode (2) et une couche de transport de porteurs de charge disposée en face de la cathode (2), couche qui est formée comme couche de transport d'électrons (8), une autre couche d'injection (9) en un autre matériau de dopage moléculaire de type n qui est en contact avec la couche de transport d'électrons (8) disposée en face de la cathode (2), étant donné que l'autre matériau de dopage moléculaire de type n présente un poids moléculaire d'au moins 300 g/mol.

3. Composant organique selon la revendication 1 ou 2, **caractérisé en ce que** la couche de transport de porteurs de charge (4 ; 8) disposée en face de l'électrode (1 ; 2) est une couche de transport de porteurs de charge dopée.

4. Composant organique selon la revendication 3, **caractérisé en ce que** la couche de transport de porteurs de charge (4 ; 8) disposée en face de l'électrode (1 ; 2) est dopée avec le matériau de dopage moléculaire.

5. Composant organique selon la revendication 2, 3 ou 4, dans la mesure où il se rapporte à la revendication 2, **caractérisé en ce que** la couche de transport de porteurs de charge (8) disposée en face de la contre-électrode (2) est une couche de transport de porteurs de charge dopée.

6. Composant organique selon la revendication 5, **caractérisé en ce que** la couche de transport de porteurs de charge (8 ; 4) disposée en face de la contre-électrode (2 ; 1) est dopée avec l'autre matériau de dopage moléculaire.

7. Composant organique selon l'une quelconque des revendications précédentes, **caractérisé en ce que** la couche d'injection (5 ; 9) est formée avec une épaisseur entre environ 0,1 nm et environ 100 nm, de préférence avec une épaisseur entre environ 0,5 nm et environ 10 nm.

8. Composant organique selon l'une quelconque des revendications 2 à 7, dans la mesure où il se rapporte à la revendication 2, **caractérisé en ce que** l'autre couche d'injection (9) est formée avec une épaisseur entre environ 0,1 nm et environ 100 nm, de préférence avec une épaisseur entre environ 0,5 nm et environ 10 nm.

9. Composant organique selon l'une quelconque des revendications 1 à 8, **caractérisé en ce que** la couche d'injection (5 ; 9) est en contact avec l'électrode (1 ; 2).

10. Composant organique selon l'une quelconque des revendications 1 à 8, **caractérisé en ce qu'**est formée entre l'électrode (1 ; 2) et la couche d'injection (5 ; 9) une couche métallique qui est en contact avec l'électrode (1 ; 2) et la couche d'injection (5 ; 9).

11. Composant organique selon l'une quelconque des revendications 2 à 10, dans la mesure où il se rapporte à la revendication 2, **caractérisé en ce que** l'autre couche d'injection (9) est en contact avec la contre-électrode (2).

12. Composant organique selon l'une quelconque des revendications 2 à 10, dans la mesure où il se rapporte à la revendication 2, **caractérisé en ce qu'** est formée entre la contre-électrode (2) et l'autre couche d'injection (9) une autre couche métallique qui est en contact avec la contre-électrode (2) et l'autre couche d'injection (9).

13. Composant organique selon l'une quelconque des revendications précédentes, **caractérisé en ce que** l'une ou plusieurs des couches organiques dans l'arrangement de couches organiques (3) sont formées comme couches évaporées sous vide.

14. Composant organique selon l'une quelconque des revendications précédentes, **caractérisé en ce que** l'une ou plusieurs des couches organiques dans l'arrangement de couches organiques (3) sont formées comme couches polymères.

15. Composant organique selon l'une quelconque des revendications précédentes ou une quelconque des revendications 2 à 14, **caractérisé en ce que** le matériau de dopage moléculaire et/ou l'autre matériau de dopage moléculaire présentent une température d'évaporation minimale d'au moins 100 °C, de préférence d'au moins 140 °C, encore mieux d'au moins 160 °C.

16. Composant organique selon l'une quelconque des revendications précédentes ou une quelconque des revendications 2 à 15, **caractérisé en ce que**, pour le matériau de dopage moléculaire et/ou l'autre matériau de dopage moléculaire, il existe une différence entre la température d'évaporation et la température de décomposition d'au moins 20 °C, de préférence d'au moins environ 40 °C, encore mieux d'au moins environ 60 °C

17. Composant organique selon l'une quelconque des revendications précédentes, **caractérisé en ce que** le matériau de dopage moléculaire de type p présente un potentiel de réduction qui est supérieur ou égal à environ 0,18 V, de préférence supérieur ou égal à environ 0,24 V par rapport à Fe / Fe⁺.

18. Composant organique selon l'une quelconque des revendications précédentes, **caractérisé en ce que** le matériau de dopage moléculaire de type n présente un potentiel d'oxydation qui est inférieur ou égal à environ -2,0 V, de préférence inférieur ou égal à environ -2,2 V par rapport à Fe / Fe⁺.

19. Composant organique selon la revendication 2 ou selon l'une quelconque des revendications 3 à 18 tant que dépendantes de la revendication 2, **caractérisé en ce que** l'autre matériau de dopage moléculaire de type n présente un potentiel d'oxydation qui est inférieur ou égal à environ -1,5 V, de préférence inférieur ou égal à environ -2,0 V et encore mieux inférieur ou égal à environ -2,2 V par rapport à Fe / Fe⁺.

20. Composant organique selon l'une quelconque des revendications précédentes, **caractérisé en ce que** l'arrangement de couches organiques (3) comprend une zone électroluminescente (6) de manière à former un composant organique électroluminescent.

21. Composant organique selon la revendication 20, **caractérisé en ce que** le composant organique électroluminescent émet vers le haut.

22. Composant organique selon la revendication 20, **caractérisé en ce que** le composant organique électroluminescent émet vers le bas.

23. Composant organique selon l'une quelconque des revendications 20 à 22, **caractérisé en ce que** le composant organique électroluminescent est transparent.
